# EUROPEAN PATENT APPLICATION

(11) **EP 1 333 443 A1**
(43) Date of publication of application: **06.08.2003**
(21) Application number: 02002377.6
(22) Date of filing: 31.01.2002
(51) Int. Cl.: G11C 5/00

(54) **Memory system**

(71) Applicant: Infineon Technologies AG, 81669 München (DE)
(72) Inventor: Kuzmenka, Maksim, Dipl.-Ing., 81829 München (DE)
(74) Representative: Schoppe, Fritz, Dipl.-Ing.

(57) **Abstract**

A memory system comprises a mother board (54) and at least one memory module having a memory module board (52a,52b) and a plurality of memory chips (60,62) located on the memory module board. At least two rows of memory chips (60,62) are arranged on a principle surface of the memory module board (52a,52b).

## Description

The present application relates to a memory system in which at least one memory module is arranged on a mother board and, in particular, a memory system for use as a computer memory subsystem.

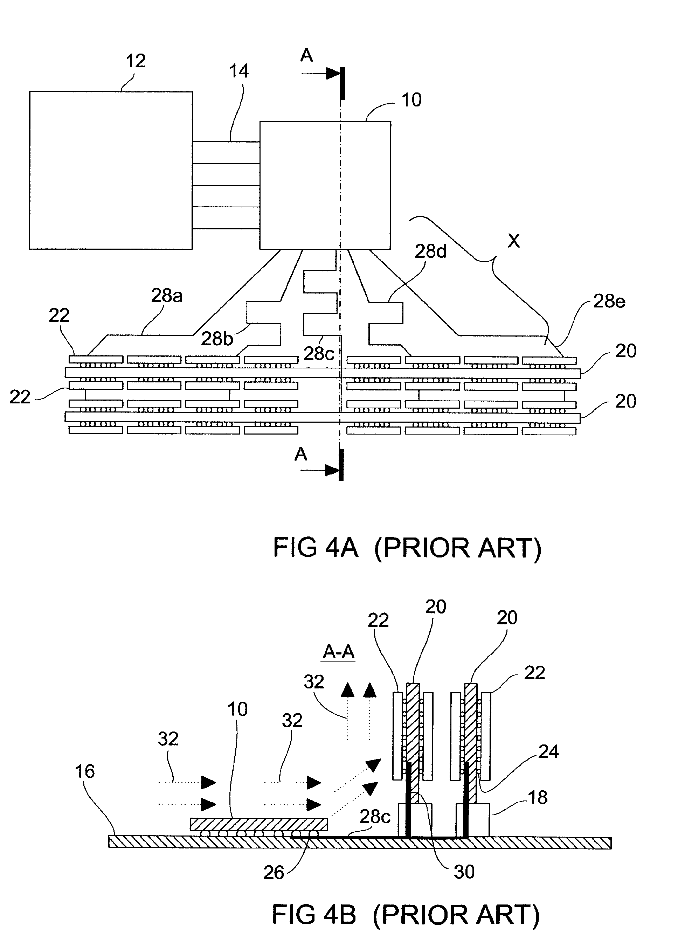

A prior art computer memory subsystem is explained hereinafter, wherein a schematical top view thereof is shown in Fig. 4A and a schematical cross-sectional view thereof along line A-A of Fig. 4A is shown in Fig. 4B.

The existing computer memory subsystem comprises a memory controller 10 connected to a central processing unit (CPU) 12 of the computer via a connecting bus 14. The memory controller 10, the CPU 12 and the connecting bus 14 are arranged on a mother board 16 (Fig. 4B) of the computer.

Also arranged on the mother board are a plurality of connectors 18 for receiving respective memory modules. Each memory module comprises a memory module board 20. The connectors 18 may be commonly used slot connectors having associated therewith a plurality of terminals connected to respective terminals on the memory module boards 20. On each principle surface of the memory module board 20 there is arranged a single row of memory chips 22. As can be seen from Fig. 4A, a single row of eight memory chips 22 is arranged on each of the principle surfaces of both memory module boards 20.

The memory chips 22 comprise commonly used BGA cases including a plurality of terminals 24. The respective memory chip terminals 24 are connected to associated contact areas on the memory module boards 20, and the contact areas are connected to the terminals of the memory module boards which are connected to respective terminals of the connectors 18. Furthermore, the terminals of the connectors 18 are electrically connected to respective terminals 26 of the memory controller 10.Thus, the memory chips 22 are properly electrically connected to the memory controller 10. The necessary connection lines are shown schematically in Fig. 4A and 4B as traces 28a, 28b, 28c, 28d and 28e.

As can be seen in Fig. 4B, the conductive traces include vertical portions 30 essentially arranged on the memory module boards 20. The conductive traces 28A to 28E and 30 are intended to represent both data lines and command-address lines (C/A lines).

In the arrangement described above with respect to Fig. 4A and 4B, a distance X indicated in Fig. 4A is about 7.6 cm (3 inches). Thus, in the existing computer memory subsystem based on DIMM modules (DIMM = dual in-line memory module), a data rate is limited due to the large distance from the memory controller to the memory chips 22 located toward the outer margins of the memory module board 20. Thus, excessive trace matching is necessary with respect to those memory chips located more centrally on the memory module boards 20 as can be seen by viewing the meander shaped traces 28b, 28c and 28d in Fig. 4A. Such structures matching the trace lengths of the "inner" memory chips to the trace lengths of the "outer" memory chips take a lot of area on the mother board. The above considerations apply to both, data lines and command/address lines, i.e. data buses and command/address buses connecting the memory chips to the memory controller.

In the existing topologies for data and command-address buses of memory systems explained above, an upper limit for most of timing parameters has substantially been reached only due to geometrical restrictions. As mentioned above, the distance between the memory controller and the outer memory chips in the first slot, i.e. the slot 18 adjacent to the memory controller 10 usually is about 7.6 cm with an associated increased line length. This means a minimum extra delay of 450 ps. In reality, this parameter can be much higher because of the non-perfect terminated traces wherein additional trace lengths result in additional capacitances, wherein an amount of time is required to charge the additional capacitances.

In addition to the long line lengths of the data buses and command-address buses of prior art memory topologies, the vertical position of the memory module boards 20 relative to the mother board 16 is an obstacle to an air flow which can be utilized for cooling the modules and the memory controller. Such air flow is indicated in Fig. 4B by arrows 32.

It is the object of the present invention to provide a memory system permitting improved access times to memory chips.

This object is achieved by a memory system according to claim 1.

The present invention provides a memory system comprising:
a mother board; and
at least one memory module comprising a memory module board and a plurality of memory chips located on the memory module board, wherein at least two rows of memory chips are arranged on a principle surface of the memory module board.

In preferred embodiments of the present invention, two rows of memory chips are arranged on both principle surfaces of the memory board. Moreover, preferably, the mother board and the memory module board are arranged such that a principle plane of the mother board and a principle plane of the memory module board are oriented in an angle of less than 45° with respect to each other. More preferably, the principle plane of the mother board and the principle plane of the memory module board are substantially parallel to each other.

The present invention is firstly based on the finding that the main reason for the increased line lengths of traditional memory architectures is the difference of the dimensions of the memory controller and the memory modules. The lateral dimensions of conventional controllers are about 3.8 cm, whereas the lateral dimension of conventional memory module boards (DIMMs) is about 12.7 cm. As explained above, in result the necessary trace length from the memory controller to the first slot is about 7.6 cm resulting in an associated delay time. A module length of 12.7 cm also brings about post-register nets in buffered modules of minimum lengths of about 6.35 cm.

Thus, the present invention is based on the recognition that a reduced length topology for memory subsystems can be achieved by arranging memory components on the memory module of the boards in two rows, rather than in one row as in prior art topologies. Thus, the length of the module, i.e. the memory module board and the length of all buses can be reduced by about 30 to 50 percent. This gives the possibility to increase working frequencies and data flow.

In addition to the two-row-arrangement, it is preferable to use absolutely different positions of memory modules when compared with prior art memory topologies. A proposed topology is to arrange the memory modules, i.e. the memory module boards, relative to the mother board such that a principle plane of the modules is substantially parallel to the principle plane of the mother board. Moreover, it is preferred to make use of two sides edge connectors, i.e. connectors leading connection lines from the memory controller to the memory chips over two edges of the memory module boards which are opposite to each other.

Beside the possibility of a space saving arrangement, an improved symmetry and reduced line lengths, the above arrangement gives rise to a further remarkable advantage. This advantage is the parallel arrangement is the existence of a direct way for an air flow through the memory subsystem for cooling of the memory modules and the memory controller making use of one air fan only. This air fan can, for example, be the CPU air fan.

To summarize, the proposed new architecture of memory subsystems allows to increase data rate close to point to point organisation due to reduced trace lengths. In addition, a better cooling efficiency can be achieved due to the possibility of a better air circulation.

Preferred embodiments of the present invention will be explained hereinafter making reference to the enclosed drawings, in which:
Fig. 1A is a schematic top view of an embodiment of the present invention;
Fig. 1B is a schematic cross-sectional view along the line B-B of Fig. 1A;
Fig. 2 and 3 are schematic cross-sectional views of alternative embodiments of the present invention;
Fig. 4A is a schematic top view of a prior art memory subsystem; and
Fig. 4B is a schematic cross-sectional view along the line A-A of Fig. 4A.

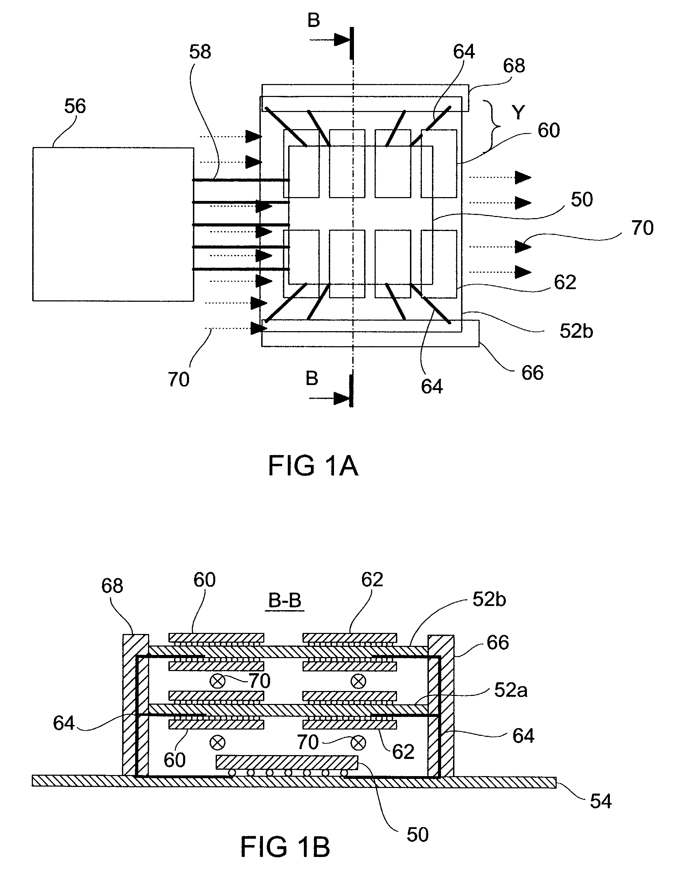

The topology of a preferred embodiment of an inventive memory system used as a computer memory subsystem is explained referring to Fig. 1A and 1B. The memory subsystem comprises a memory controller 50, a first memory module and a second memory module. The memory controller 50 is arranged on a mother board 54. In preferred embodiments of the present invention, the mother board 54 is a computers mother board having arranged thereon a central processing unit (CPU) 56. Respective terminals of the CPU 56 are connected to respective terminals of the memory controller 51 via a connection bus 58.

The first memory module comprises a first memory module board 52a and a plurality of memory chips 60, 62 arranged thereon. The second memory module comprises a second memory module board 52b and plurality of memory chips 60, 62 arranged thereon. The memory chips may have a conventional BGA design (BGA = Ball Grid Array). The memory modules 60 and 62 are arranged on the principle surfaces of the respective memory module board in two rows, wherein the respective modules 60 form a first row and the respective modules 62 form a second row.

The memory module boards 52a and 52b are supported by two carriers 66 and 68. The carriers 66 and 68 provide for a mechanical support for the memory module boards 52a and 52b, on the one hand, and for an electrical connection of the memory chips 60 and 62 to the memory controller 50, on the other hand.

To be more specific, data outputs and command-address outputs of the memory controller 50 are connected to data inputs and command-address inputs, respectively, of memory chips 60, 62 located on the memory module boards 52a and 52b. The corresponding connections are indicated schematically by electrical connections 64. To achieve those electrical connections, the carriers 66 and 68 may include slot connectors (not shown), into which the memory module boards 52a and 52b are inserted so that contact areas on the memory module boards are electrically connected to terminals of the slot connectors. In addition, the carriers 66 and 68 comprise means for providing electrical connection between the slot connectors and contact areas on the motherboard. Thus, connections comparable to those between prior art memory modules and slot connectors 18 (Fig. 1A and 1B) are obtained.

Electrical connections between the memory chips and conductive traces on the memory module boards and electrical connections between the memory controller and conductive traces on the motherboard are obtained in a usual manner. Thus, electrical connections between respective terminals of the memory controller and respective terminals of the memory chips are obtained.

The carriers 66 and 68 support the memory module boards at two opposite edges thereof to provide mechanical stability, on the one hand, and reduced trace lengths of the electrical connections, on the other hand. As indicated above, the memory chips 60 and 62 are arranged on the memory module boards 52a and 52b in two rows. The memory chips 60 form respective first rows and are electrically connected via the left edge of the memory module boards. The memory chip 62 form respective second rows and are electrically connected via the right edge of the memory module boards. As can be seen from Fig. 1B, two rows of memory chips 60 and 62 are arranged on both principle surfaces of the memory module boards 52a and 52b.

It is to be noted that the memory controller 50 and the portions of the connection lines 64 located on the mother board 54 are shown in Fig. 1A by solid lines for the purpose of illustration, although they actually are hidden below the memory module boards.

In the topology explained above referring to Fig. 1A and 1B, the distance Y indicated in Fig. 1A may be about 3.8 cm assuming the dimensions of memory controllers and memory chips as usually used in DIMM topologies. Thus, according to the inventive topology, trace lengths can be twice shorter than in conventional memory topologies. Due to the reduced length of traces reduced access times to the memory chips can be obtained.

A further remarkable advantage of the substantially parallel arrangement of the mother board 54 and the memory module boards 52a and 52b is the fact that good cooling conditions for the memory modules and the memory controller are provided. To be more specific, a single fan can be used to produce an air flow, which is shown by arrows 70, for cooling both the memory modules (i.e. the memory module boards and the memory chips arranged thereon) and the memory controller 50. Moreover, it is preferred to arrange the inventive memory subsystem on the mother board 54 such that the air flow from the fan (not shown) associated with and normally arranged on the CPU 56 can be used for cooling the memory controller 50 and the memory modules. Thus, an improved cooling efficiency is obtained due to the better air circulation enabled by the inventive memory subsystem topology.

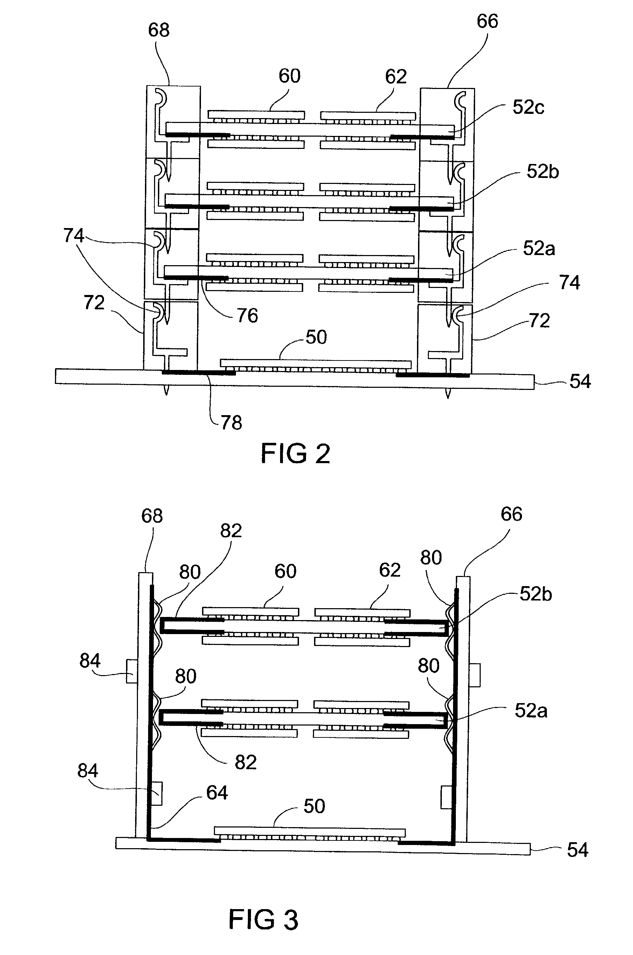

Fig. 2 and 3 show two possible implementations of the inventive memory subsystem in greater detail.

According to Fig. 2, a plurality of three memory module boards 52a, 52b and 52c are arranged on the mother board 54. The carriers 66 and 68 have a modular construction such that same easily allow for addition of further memory module boards. According to Fig. 2, each carrier is comprised of four carrier modules 72. Preferably, the carrier modules 72 have an identical construction and comprise features which permit stacking of a plurality of memory module boards substantially in parallel to the mother board 54 on top of each other. In addition, the carrier module 72 comprise features permitting the required electrical connections. Such features can comprise contact structures 74 which preferably provide for a springy contact between the respective carrier modules 72. The contact structures 74 include further features permitting an electrical connection to respective bus connection structures 76 on the memory module boards 52a to 52c. The lowermost carrier module provides for electrical connections to contact areas of connection bus structures 78 on the mother board 54. It is preferable that the contact structures on the mother board 54 have an adapted construction (via connector or the like) such that the carrier modules 72 providing a connection to the contact areas on the mother board and the carrier modules 72 providing a connection to another carrier module may have the same construction.

Another implementation of an inventive memory subsystem topology is shown in Fig. 3. In this implementation, springy contacts 80 are provided on the inner surfaces of the carriers 66 and 68. The springy contacts 80 are configured to permit insertion of soldered clips 82 provided on the memory module boards 52a and 52b. Thus, on the one hand, mechanical support for the memory module boards 52a and 52b is obtained. On the other hand, an electrical connection is achieved via the springy contacts 80 and the soldered clips 82. As in Fig. 1B, connection lines 64 are schematically indicated in Fig. 3. In addition, braces 84 can be provided to improve the mechanical stability of the carrier 66 and 68.

In the above embodiments, the memory module boards were arranged relative to the mother board such that principle planes thereof were substantially in parallel to the principle plane of the mother board. However, the present invention is not restricted to exactly such a construction. Rather, each memory module board may have a roof-like structure, wherein one row of memory chips being arranged on one side of the ridge of the roof-like structure and the other row being arranged on the other side thereof. Moreover, one might take into consideration constructions wherein the memory module boards are arranged slightly oblique when compared with the mother board. The definition that the principle plane of the mother board and the principle plane of the memory module board are oriented in an angle of less than 45° with respect to each other is intended to encompass such cases. Moreover, it is to be noted that more than two rows of memory chips might be placed on one or both principle surfaces of the memory module boards.

Reference Numbers
- 10: memory controller
- 12: CPU
- 14: connection means
- 16: mother board
- 18: connectors
- 20: memory module boards
- 22: memory chips
- 24: memory chip terminals
- 26: memory controller terminals
- 28a to 28e: conductive traces
- 30: conductive traces
- 32: air flow
- 50: memory controller
- 52a,52b,52c: memory module boards
- 54: mother board
- 56: CPU
- 58: connection bus
- 60,62: memory chips
- 64: electrical connections
- 66,68: carriers
- 70: air flow
- 72: carrier modules
- 74: contact structure
- 76,78: connection buses
- 80: springy contacts
- 82: soldered clips
- 84: braces

## Claims

1. A memory system comprising:
a mother board (54); and
at least one memory module comprising a memory module board (52a,52b,52c) and a plurality of memory chips (60,62) located on the memory module board, wherein
at least two rows of memory chips (60,62) are arranged on a principle surface of the memory module board (52a,52b,52c).

2. A memory system according to claim 1, wherein two rows of memory chips (60,62) are arranged on both principle surfaces of the memory module board (52a,52b,52c).

3. A memory system according to claim 1 or 2, wherein the mother board (54) and the memory module board (52a,52b,52c) are arranged such that a principle plane of the mother board (54) and a principle plane of the memory module board (52a,52b,52c) are oriented in an angle of less than 45° with respect to each other.

4. A memory system according to one of claims 1 to 3, wherein the principle plane of the mother board (54) and the principle plane of the memory module board (52a,52b,52c) are substantially parallel to each other.

5. A memory system according to one of claims 1 to 4, further comprising a memory controller (50) arranged on the mother board (54) wherein connection lines (64) connecting the memory chip (60,62) to the memory controller (50) are led to the memory chip (60,62) from two edges of the memory module board (52a,52b,52c).

6. A memory system according to one of claims 1 to 5, wherein the memory module board (52a,52b,52c) is mechanically supported at two edges thereof which are opposite to each other.

7. The memory system according to one of claims 1 to 6, wherein a plurality of memory module boards (52a,52b,52c) are stacked on top of each other on the mother board (54).
